# EUROPÄISCHE PATENTSCHRIFT

(11) **EP 0 971 568 B1**
(45) Veröffentlichungstag und Bekanntmachung des Hinweises auf die Patenterteilung: **17.05.2006**
(21) Anmeldenummer: 99106486.6
(22) Anmeldetag: 30.03.1999
(51) Int. Cl.: H05K 1/00

(54) **Baugruppenträger**
Electronic component
Bâti électronique

(30) Priorität: 02.07.1998 DE 19829581
(43) Veröffentlichungstag der Anmeldung: 12.01.2000
(73) Patentinhaber: ROBERT BOSCH GMBH, 70442 Stuttgart (DE)
(72) Erfinder: Roozenbeek, Herman, 71701 Schwieberdingen (DE); Magiera, Michael, 71701 Schwieberdingen (DE); Koenighaus, Alfons, 74343 Sachsenheim (DE); Butschkau, Werner, 74321 Bietigheim-Bissingen (DE); Buck, Juergen, 71636 Ludwigsburg (DE)

(56) Entgegenhaltungen:
- GB-A- 2 294 363

## Beschreibung

### Stand der Technik

Die Erfindung betrifft einen Baugruppenträger mit den im Oberbegriff des Anspruchs 1 angegebenen Merkmalen.

Es ist bereits bekannt, Baugruppenträger für elektronische Schaltungen, wie beispielsweise Mehrlagen-Leiterplatten oder keramische Multilayer, in elektronische Steuergeräte eines Kraftfahrzeuges einzubauen, um die Motorleistung in Abhängigkeit von verschiedenen, der Steuerschaltung zugeführten Daten, wie zum Beispiel der Fahrtgeschwindigkeit, zu steuern. Um eine optimale Funktion der Steuerschaltung in Abhängigkeit von den jeweiligen Rahmenbedingungen zu erreichen, muß das in der Steuerschaltung enthaltene Steuerprogramm an den laufenden Motor angepaßt werden. Hierzu ist beispielsweise aus der deutschen Patentanmeldung DE 197 04 487 bekannt, einen elektronischen Rechner, zum Beispiel einen PC, über eine erweiterte Schnittstelle, an die auf dem Mehrlagensubstrat angeordnete Steuerschaltung anzuschließen. Als Schnittstelle wird eine mit der Steuerschaltung elektrisch verbundene weitere elektronische Schaltung, ein sogenannter Emulator-Tast-Kopf verwandt, der auf einem zweiten Baugruppenträger angeordnet ist. Mit dem Emulator-Tast-Kopf können in einem Applikationsgerät die Steuerparameter der Steuerschaltung an den laufenden Motor angepaßt werden. Sind die optimalen Parameter erst einmal bestimmt worden, werden anschließend in der Serienfertigung Baugruppenträger mit elektronischen Schaltungen hergestellt, in deren elektronischen Speicher diese zuvor bestimmten Steuerparameter eingelesen werden. In den Seriengeräten wird der Emulator-Tast-Kopf dann nicht mehr benötigt. Als nachteilig ist anzusehen, daß der Emulator-Tast-Kopf, der in den Applikationsgeräten auf dem zweiten Baugruppenträger angeordnet ist, über eine sehr große Anzahl von elektrischen Verbindungen an die Steuerschaltung auf dem ersten Baugruppenträger angeschlossen werden muß. Beide Baugruppenträger müssen hierfür mit geeigneten, speziell ausgestalteten Kontaktelementen versehen werden, wobei die Herstellung derartiger Verbindungen extrem aufwendig und teuer ist und eine Abänderung des Schaltungslayouts der Steuerschaltung erforderlich macht. Darüber hinaus ist die Verbindung störanfällig und bei Vibrationsbelastungen nicht ausreichend zuverlässig.

### Vorteile der Erfindung

Durch den erfindungsgemäßen elektrischen Baugruppenträger mit den kennzeichnenden Merkmalen des Anspruchs 1 werden die beim Stand der Technik auftretenden Nachteile vermieden. Besonders vorteilhaft ist, daß zumindest ein Teil der für die Anpassung der Steuerparameter der Steuerschaltung benötigten weiteren elektrischen und/oder elektronischen Bauelemente innerhalb eines nur für diese Bauelemente vorgesehenen Abschnitts auf dem gleichen Mehrlagensubstrat wie die Steuerschaltung angeordnet ist und daß zusätzlich zu den für die Verdrahtung der Steuerschaltung benötigten Leiterbahnlagen wenigstens eine innere Leiterbahnlage vorgesehen ist, in der solche Leiterbahnen angeordnet sind, welche die zur Steuerschaltung gehörenden Bauelemente mit den weiteren elektrischen und/oder elektronischen Bauelementen elektrisch verbinden. Hierdurch wird einerseits eine zuverlässige und preiswert herzustellende elektrische Verbindung der weiteren Bauelemente mit der Steuerschaltung ermöglicht und andererseits erreicht, daß keine weitreichenden Abänderungen an der Leiterbahnführung und dem Schaltungslayout bei den in Serie hergestellten Baugruppenträgern erforderlich werden.

Vorteilhaft ist, wenn die weiteren Bauelemente wenigsten ein Steckerteil umfassen, über das ein mit einer als Emulator-Tast-Kopf ausgelegten Schaltung versehener zweiter Baugruppenträger an die Steuerschaltung anschließbar ist. Da das Steckerteil nur über die wenigstens eine zusätzlich vorgesehene innere Lage mit der Steuerschaltung verbunden ist, macht die Anordnung des Steckerteils auf dem mit der Steuerschaltung versehenen ersten Baugruppenträger keine aufwendige Abänderung des Schaltungslayouts erforderlich.

Vorteilhaft ist weiterhin, wenn die weiteren Bauelemente eine zusätzlich zur Steuerschaltung auf dem Mehrlagensubstrat angeordnete, als Emulator-Tast-Kopf ausgelegte zweite elektronische Schaltung bilden, mittels der die Steuerparameter der Steuerschaltung gelesen und geändert werden können. In diesem Fall ist kein zweiter Baugruppenträger erforderlich, da die für die Optimierung der Steuerparameter benötigten Bauelemente auf dem ersten Baugruppenträger angeordnet sind.

Die weiteren nicht zur Steuerschaltung gehörenden Bauelemente, Leiterbahnen und Durchkontaktierungen, welche auf einem räumlich von der Steuerschaltung abgegrenzten Abschnitt vorgesehen sind und zur Auffindung der optimalen Steuerparameter benötigt werden, können ebenso wie die wenigstens eine zusätzlich vorgesehene innere Leiterbahnlage bei der späteren Serienproduktion der Baugruppenträger einfach weggelassen werden, ohne daß für die Serienproduktion eine vollständige Abänderung und Umgestaltung des Leiterbahnbildes und des Schaltungslayouts erforderlich wird. Hierdurch sind erhebliche Preiseinsparungen möglich.

### Zeichnungen

Ein Ausführungsbeispiel der Erfindung ist in den Zeichnungen dargestellt und wird in der nachfolgenden Beschreibung näher erläutert. Es zeigt
Fig. 1 eine Draufsicht auf eine erstes Ausführungsbeispiel eines erfindungsgemäßen Baugruppenträgers mit der Steuerschaltung und den weiteren Bauelementen,
Fig. 2 einen Querschnitt durch den Baugruppenträger aus Fig. 1 entlang der Linie II-II,
Fig. 3 eine Draufsicht auf ein zweites Ausführungsbeispiel eines erfindungsgemäßen Baugruppenträgers.

### Beschreibung der Ausführungsbeispiele

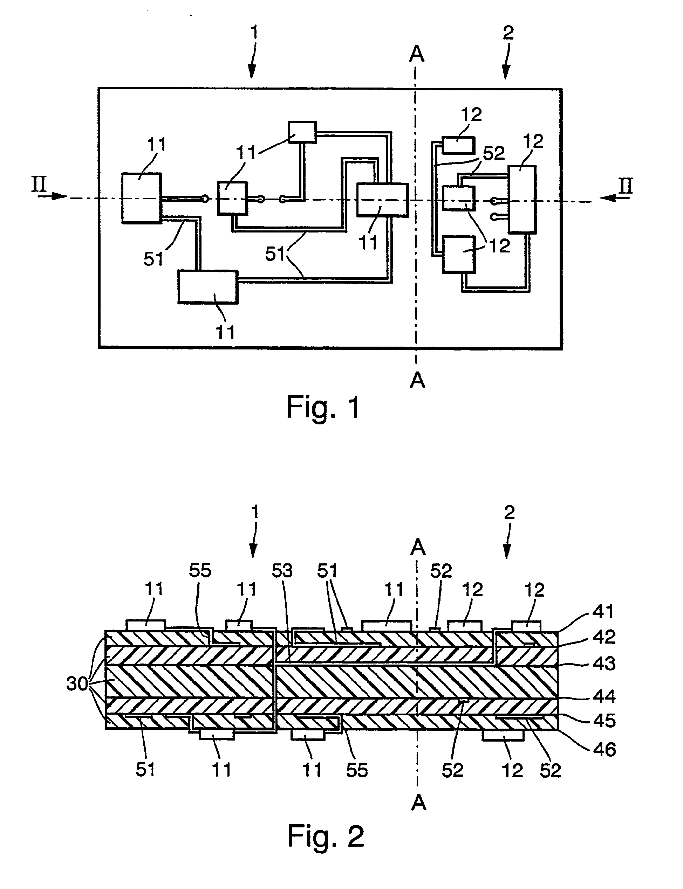

Ein erstes Ausführungsbeispiel des erfindungsgemäßen Baugruppenträgers ist in Fig. 1 und Fig. 2 gezeigt. Bei dem hier gezeigten Baugruppenträger handelt es sich um eine Mehrlagen-Leiterplatte. Es ist aber genauso möglich, ein keramisches Mehrlagensubstrat (Multilayer) oder ein anderes geeignetes Mehrlagensubstrat zu verwenden. Das Mehrlagensubstrat ist in dem hier dargestellten Beispiel auf der Oberseite und Unterseite mit elektrischen und/oder elektronischen Bauelementen 11,12, wie beispielsweise Mikroprozessoren, Kondensatoren, Widerständen, Steckerbauelementen usw. bestückt. Natürlich kann auch ein einseitig bestücktes Mehrlagensubstrat verwandt werden. Wie in Fig. 2 zu erkennen ist, umfaßt das Mehrlagensubstrat mehrere durch Isolierstofflagen 30 getrennte Leiterbahnlagen 41-46. In den Leiterbahnlagen sind die für die Verdrahtung der elektrischen und/oder elektronischen Bauelemente benötigten Leiterbahnen 51,52,53 angeordnet. Die Leiterbahnen verschiedener Leiterbahnlagen können über Durchkontaktierungen 55 in bekannter Weise elektrisch miteinander verbunden sein. Bei dem dargestellten Ausführungsbeispiel bilden die links von der Linie A-A in Fig. 1 und Fig. 2 auf dem Mehrlagensubstrat angeordneten Bauelemente 11 eine vollständige elektronische Steuerschaltung, wie sie beispielsweise in einem elektronischen Steuergerät eines Kraftfahrzeuges zur Steuerung der Motorfunktionen verwandt wird. Zur Steuerschaltung gehört ein elektronischer Speicher, in dem die zur Steuerung der Motorfunktionen benötigten Steuerparameter gespeichert sind. Der mit der Steuerschaltung versehene Bereich 1 der Mehrlagen-Leiterplatte wird im folgenden Steuerschaltungsteil genannt. Die Verdrahtung der zur Steuerschaltung gehörenden Bauelemente 11 erfolgt über Leiterbahnen 51, welche nur innerhalb des Steuerschaltungsteils 1 auf den äußeren Leiterbahnlagen 41,46 und den beiden Innenlagen 42,45 vorgesehen sind. Wie in Fig. 1 und Fig. 2 zu erkennen ist, sind weitere, nicht zur Steuerschaltung gehörende Bauelemente 12 in einem von dem mit dem Steuerschaltungsteil 1 räumlich abgegrenzten Abschnitt 2 rechts von der Linie A-A auf den beiden Bestückungsseiten des Mehrlagensubstrats angeordnet. Vorteilhafter Weise bildet der Abschnitt 2 einen Randabschnitt des Mehrlagensubstrats. Der mit den weiteren Bauelemente 12 versehene Abschnitt wird im folgenden als Applikationsteil 2 bezeichnet. Bei dem in den Fig. 1 und 2 dargestellten ersten Ausführungsbeispiel umfassen die weiteren elektrischen und/oder elektronischen Bauelemente 12 eine erweiterte Schnittstelle, einen sogenannter Emulator-Tast-Kopf. In diesem Ausführungsbeispiel sind daher alle zum Emulator-Tast-Kopf gehörenden Bauelemente 12 innerhalb des Applikationsteils 2 direkt auf dem in Fig. 1 und Fig. 2 gezeigten Mehrlagensubstrat angeordnet. Weiterhin weist der Applikationsteil 2 noch einen nicht dargestellten Steckanschluß zum Anschluß eines Rechners, beispielsweise eines PC's auf. Wie noch ausführlicher dargestellt wird, ermöglicht es der Emulator-Tast-Kopf, die Steuerparameter der Steuerschaltung zu lesen und zu ändern und optimal an den Betrieb der Steuerschaltung anzupassen.

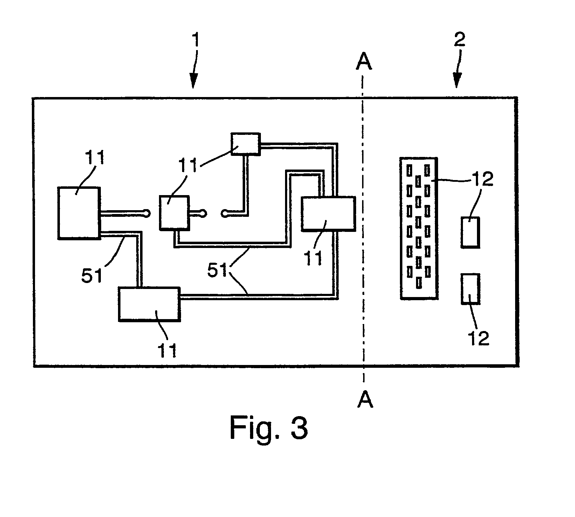

In einem zweiten Ausführungsbeispiel ist vorgesehen, daß die weiteren Bauelemente 12 des Applikationsteils 2, wie in Fig. 3 dargestellt, wenigstens ein Steckerteil und gegebenenfalls noch weitere elektronische Treiber-Bauelemente umfassen. Das Steckerteil 12 ist mit dem Gegenstecker eines zweiten Baugruppenträgers koppelbar. Auf dem zweiten, nicht dargestellten Baugruppenträger ist dann ein als Emulator-Tast-Kopf ausgelegtes Schaltungsteil angeordnet, das mit einem elektronischen Rechner, beispielsweise einem PC elektrisch verbunden ist. Das Steuerschaltungsteil 1 des in Fig. 3 gezeigten Baugruppenträgers ist dabei gleichartig zu dem in Fig. 2 dargestellten Steuerschaltungsteil aufgebaut.

In beiden Ausführungsbeispielen erfolgt die Verdrahtung der weiteren Bauelemente 12 über Leiterbahnen 52, welche innerhalb des Applikationsteils 2 auf den Leiterbahnlagen 41-46 vorgesehen sind. Zur optimalen Anpassung der Steuerparameter mittels des Emulator-Tast-Kopfes müssen in beiden oben beschriebenen Ausführungsbeispielen die weiteren Bauelemente 12 mit den im Steuerschaltungsteil 1 vorgesehenen Bauelementen 11 elektrisch verbunden werden. Zu diesem Zweck sind, wie besonders gut in Fig. 2 zu erkennen ist, für die elektrischen Verbindungen zwei spezielle Leiterbahnlagen 43 und 44 vorgesehen, in denen Leiterbahnen 53 angeordnet sind, welche die weiteren Bauelemente 12 des Applikationsteils 2 mit den Bauelementen 11 des Steuerschaltungsteils 1 elektrisch verbinden und welche direkt an den Adreß- und Datenbus der Steuerschaltung angeschlossen sind. Es ist aber nicht unbedingt erforderlich, zwei zusätzliche Leiterbahnlagen vorzusehen. Es ist auch möglich hierfür nur eine, vier oder jede beliebige andere Anzahl an zusätzlichen Leiterbahnlagen in dem Mehrlagensubstrat vorzusehen. Auch können, wie in Fig. 2 dargestellt, gegebenenfalls noch Leiterbahnen 52, welche nur die weiteren Bauelemente 12 des Applikationsteils 2 untereinander verbinden auf den zusätzlichen Leiterbahnlagen 43,44 angeordnet sein. Wichtig ist, daß keine zur Steuerschaltung gehörenden Leiterbahnen 51 auf den zusätzlich vorgesehenen Leiterbahnlagen 43,44 angeordnet sind. Da die Kontaktierung von Steuerschaltungsteil 1 und Applikationsteil 2 über Leiterbahnen des Mehrlagensubstrats erfolgt, ist sie besonders zuverlässig bei Vibrationsbelastungen und preisgünstig und einfach herstellbar.

Der mit dem Applikationsteil 2 versehene Baugruppenträger der in den Figuren 1 bis 3 dargestellten Ausführungsbeispiele ermöglicht es, in einem als Applikationsgerät hergestellten Steuergerät die Steuerparameter optimal an den laufenden Motor anzupassen. Der Emulator-Tast-Kopf weist hierfür neben einem Mikroprozessor und anderen elektronischen Bauelementen einen RAM-Speicher auf, in welchem die Steuerparameter gespeichert sind. Im Betrieb des Applikationsgerätes greift das Steuerprogramm des Steuerschaltungsteils 1 nicht auf die im Speicher des Steuerschaltungsteils, welcher beispielsweise ein FLASH-EPROM sein kann, enthaltenen Steuerparameter zurück, sondern liest die Steuerparameter aus dem RAM-Speicher des Emulator-Tast-Kopfes. Mit einem an den Emulator-Tast-Kopf angeschlossenen PC können nun diese im RAM-Speicher des Emulator-Tast-Kopfes enthaltenen Steuerparamter beliebig vorgegeben werden. Ausgehend von bestimmten Anfangsparametern können durch Variation die für die Arbeitsweise des Motors optimalen Steuerparameter aufgefunden werden.

Sind die optimalen Steuerparameter mit dem oben beschriebenen Applikationsgerät erst einmal aufgefunden, können anschließend solche Baugruppenträger in Serie hergestellt werden, die den Applikationsteil 2 nicht mehr aufweisen. Die mit dem Applikationsgerät aufgefundenen optimalen Werte für die Steuerparameter werden dann auf den Speicher des Seriengerätes, beispielsweise ein FLASH-EPROM übertragen. Vorteilhaft dabei ist, daß die in Serie gefertigten Mehrlagensubstrate eine Leiterbahnführung bzw. ein Leiterbahnbild aufweisen, das dem Leiterbahnbild des in den Figuren 1 bis 3 links von der Linie A-A angeordneten Abschnitts entspricht, wobei die zusätzlich vorgesehenen Leiterbahnlagen 43 und 44 mit den Leiterbahnen 53 und denjenigen Durchkontaktierungen, welche zur Verbindung der Leiterbahnen 53 mit den Leiterbahnen der Lagen 41,42,45 und 46 im Steuerschaltungsteil 1 benötigt wurden, bei den in Serie gefertigten Baugruppenträgern einfach weggelassen werden. Diese Vorgehensweise hat den erheblichen Vorteil, daß das Layout bzw. das Leiterbahnbild der Leiterbahnen 51 des Steuerschaltungsteils für die Serienfertigung nicht mehr geändert werden muß. Hätte man die zusätzlichen Leiterbahnlagen 43 und 44 im Applikationsgerät nicht vorgesehen, und statt dessen die weiteren Bauelemente 12 zwischen den Bauelementen 11 der Steuerschaltung auf dem Mehrlagensubstrat angeordnet und über die vorhandenen Leiterbahnlagen 41,42 und 44,45 des Steuerschaltungsteils mit der Steuerschaltung verbunden, so würden bei den in Serie gefertigten Mehrlagensubstraten, welche die weiteren Bauelemente 12 und die für deren Verdrahtung benötigte Leiterbahnen 53,52 nicht mehr aufweisen, große Freiräume in der Schaltung verbleiben, welche eine komplette Umarbeitung des Layouts der Schaltung erforderlich machen würden. Dieser Nachteil wird bei den in den Figuren 1 bis 2 und dem in Fig. 3 gezeigten Baugruppenträger vermieden, da bei dem für die Bestimmung der optimalen Steuerparameter verwandten Baugruppenträger des Applikationsgerätes das Leiterbahnlayout des Steuerschaltungsteils 1 der ohne den Applikationsteil 2 in Serie hergestellten Baugruppenträger bis auf die nicht mehr vorhandenen Lagen 43,44 unverändert bleibt. Dies setzt allerdings voraus, daß keine zur Steuerschaltung gehörenden Leiterbahnen auf den zusätzlichen Leiterbahnlagen 43 und 44 des Applikationsgerätes angeordnet sind.

## Patentansprüche

1. Baugruppenträger für elektronische Schaltungen, umfassend ein mit elektrischen und/oder elektronischen Bauelementen (11) bestücktes Mehrlagensubstrat, das mehrere durch Isolierstoffschichten (30) getrennte Leiterbahnlagen (41,42,45, 46) mit Leiterbahnen (51) zur elektrischen Verbindung der Bauelemente (11) sowie Durchkontaktierungen (55) zur elektrischen Verbindung der Leiterbahnen verschiedener Leiterbahnlagen aufweist, wobei die Bauelemente, Leiterbahnen und Durchkontaktierungen eine elektronische Steuerschaltung bilden, **dadurch gekennzeichnet, daß** das Mehrlagensubstrat wenigstens einen von dem mit der Steuerschaltung versehenen Bereich (1) des Mehrlagensubstrats räumlich abgegrenzten Abschnitt (2) aufweist, auf dem weitere Bauelemente (12) angeordnet sind, die ausschließlich solche elektrischen und/oder elektronischen Bauelemente (12) sind, die nicht zur Steuerschaltung gehören, und daß wenigstens eine innere Leiterbahnlage (43,44) in dem Mehrlagensubstrat vorgesehen ist, in der ausschließlich Leiterbahnen (53) zur elektrischen Verbindung der weiteren Bauelemente (12) mit den Bauelementen (11) der Steuerschaltung angeordnet sind.

2. Baugruppenträger nach Anspruch 1, **dadurch gekennzeichnet, daß** die weiteren Bauelemente (12) wenigstens ein Steckerteil zum Anschluß eines mit einer Emulator-Tast-Kopf-Schaltung versehenen zweiten Baugruppenträgers umfassen.

3. Baugruppenträger nach Anspruch 1, **dadurch gekennzeichnet, daß** die weiteren Bauelemente (12) ein als Emulator-Tast-Kopf ausgelegtes Schaltungsteil aufweisen, über das die Steuerparameter der Steuerschaltung gelesen und geändert werden können.

4. Baugruppenträger nach einem der vorstehenden Ansprüche, **dadurch gekennzeichnet, dass** in der wenigstens einen Leiterbahnlage (43, 44) Leiterbahnen (52) zur elektrischen Verbindung der weiteren Bauelemente (12) untereinander angeordnet sind.

5. Verfahren unter Verwendung des Baugruppenträgers mit den Merkmalen eines der Ansprüche 1 bis 4, wobei in einem ersten Schritt optimale Werte für die in dem elektronischen Speicher der Steuerschaltung des Baugruppenträgers gespeicherten Steuerparameter mittels der weiteren Bauelemente (12) im Betrieb der Steuerschaltung aufgefunden werden und in einem folgenden Schritt die optimalen Werte der Steuerparameter auf den elektronischen Speicher eines zweiten Mehrlagensubstrats übertragen werden, dessen Leiterbahnbild dem mit der Steuerschaltung versehenen Leiterbahnbild des Bereichs (1) des ersten Mehrlagensubstrats gleicht, wobei das zweite Mehrlagensubstrat die wenigstens eine innere Leiterbahnlage (43,44) und den mit den weiteren Bauelementen (12) versehenen Abschnitt (2) nicht aufweist.

## Claims

1. Mounting rack for electronic circuits, said mounting rack comprising a multilayer substrate which is fitted with electrical and/or electronic components (11) and has a plurality of conductor track layers (41, 42, 45, 46) which are separated by means of insulating material layers (30) and have conductor tracks (51) for electrically connecting the components (11) and plated-through holes (55) for electrically connecting the conductor tracks of various conductor track layers, the components, conductor tracks and plated-through holes forming an electronic control circuit, **characterized in that** the multilayer substrate has at least one section (2) which is spatially delimited from that region (1) of the multilayer substrate which is provided with the control circuit, further components (12) which are exclusively those electrical and/or electronic components (12) which do not belong to the control circuit being arranged in said section, and **in that** at least one inner conductor track layer (43, 44) in which exclusively conductor tracks (53) for electrically connecting the further components (12) to the components (11) of the control circuit are arranged is provided in the multilayer substrate.

2. Mounting rack according to Claim 1, **characterized in that** the further components (12) comprise at least one connector part for connecting a second mounting rack that is provided with an emulator probe head circuit.

3. Mounting rack according to Claim 1, **characterized in that** the further components (12) have a circuit part which is in the form of an emulator probe head and can be used to read and change the control parameters of the control circuit.

4. Mounting rack according to one of the preceding claims, **characterized in that** conductor tracks (52) for electrically connecting the further components (12) to one another are arranged in the at least one conductor track layer (43, 44).

5. Method using the mounting rack having the features of one of Claims 1 to 4, the further components (12) being used, in a first step, during operation of the control circuit, to find optimal values for the control parameters which are stored in the electronic memory of the control circuit of the mounting rack and, in a subsequent step, the optimal values of the control parameters being transmitted to the electronic memory of a second multilayer substrate whose conductor track pattern is similar to that conductor track pattern of the region (1) of the first multilayer substrate which is provided with the control circuit, the second multilayer substrate not having the at least one inner conductor track layer (43, 44) and the section (2) which is provided with the further components (12).

## Revendications

1. Châssis pour circuit électroniques, comprenant un substrat à plusieurs couches garni de composants électriques et/ou électroniques (11), qui présente plusieurs couches de pistes conductrices (41, 42, 45, 46) séparées par des couches d'isolant (30) et munies de pistes conductrices (51) pour la liaison électrique des composants (11) ainsi que de connexions transversales (55) pour la liaison électrique des pistes conductrices de différentes couches de pistes conductrices, les composants, les pistes conductrices et les connexions transversales formant un circuit de commande électronique,
**caractérisé en ce que**
le substrat à plusieurs couches présente au moins un segment (2) délimité dans l'espace par la zone (1) du substrat à plusieurs couches munie du circuit de commande, et sur lequel sont disposés d'autres composants (12) qui sont exclusivement les composants électriques et/ou électroniques (12) qui n'appartiennent pas au circuit de commande, et au moins une couche de pistes conductrice intérieure (43, 44) prévue dans le substrat à plusieurs couches comporte exclusivement des pistes conductrices (53) pour la liaison électrique des autres composants (12) avec les composants (11) du circuit de commande.

2. Châssis selon la revendication 1,
**caractérisé en ce que**
les autres composants (12) comprennent au moins une partie de connecteur pour la connexion d'un deuxième châssis muni d'un circuit de sonde d'émulateur.

3. Châssis selon la revendication 1,
**caractérisé en ce que**
les autres composants (12) présentent une partie de circuit conçue sous forme de sonde d'émulateur, par laquelle les paramètres de commande du circuit de commande peuvent être lus et modifiés.

4. Châssis selon l'une des revendications précédentes,
**caractérisé en ce que**
des pistes conductrices (52) sont disposées les unes en dessous des autres dans la couche de pistes conductrices (43, 44) pour la liaison électrique des autres composants (12).

5. Procédé utilisant le châssis présentant les caractéristiques de l'une des revendications 1 à 4,
**caractérisé en ce que**
dans une première étape, des valeurs optimales pour les paramètres de commande stockés dans la mémoire électronique du circuit de commande du châssis sont trouvées pendant le fonctionnement du circuit de commande, et dans une étape suivante les valeurs optimales des paramètres de commande sont transmises à la mémoire électronique d'un deuxième substrat à plusieurs couches dont l'image de pistes conductrices est identique à l'image de pistes conductrices, munie du circuit de commande, de la zone (1) du premier substrat à plusieurs couches, le deuxième substrat à plusieurs couches ne présentant ni la couche de piste conductrice intérieure (43, 44) ni le segment (2) muni des autres composants (12).
